# EUROPÄISCHE PATENTANMELDUNG

(11) **EP 0 911 890 A2**
(43) Veröffentlichungstag der Anmeldung: **28.04.1999**
(21) Anmeldenummer: 98810989.8
(22) Anmeldetag: 01.10.1998
(51) Int. Cl.: H01L 39/24

(54) **Verfahren zum Legieren einer Edelmetall-Bypassschicht eines Hochtemperatur-supraleiters**

(30) Priorität: 24.10.1997 DE 19746975
(71) Anmelder: ABB RESEARCH LTD., 8050 Zürich (CH)
(72) Erfinder: Chen, Makan, Dr., 5405 Baden-Dättwil (CH); Lakner, Martin, Dr., 5413 Birmenstorf (CH); Paul, Willi, Dr., 5430 Wettingen (CH)
(74) Vertreter: Lück, Gert, Dr.

(57) **Zusammenfassung**

Keramische Hochtemperatursupraleiter (1), die als Strombegrenzer in Wechselstromleitungen eingesetzt werden, sollten eine Bypaßschicht (2) aufweisen, deren spezifischer elektrischer Widerstand gegenüber demjenigen eines Edelmetalles um mehr als das 10fache erhöht ist. Um dies zu erreichen, wird die Edelmetall-Bypaßschicht (2) des Hochtemperatursupraleiters (1), vorzugsweise aus Silber, mit einem Nichtedelmetall, vorzugsweise Pb oder Bi oder Ga oder Al, durch eine thermische Behandlung legiert. Für das Aufbringen einer Legierungsmetallschicht (3) auf die Edelmetall-Bypaßschicht (2), des Hochtemperatursupraleiters (1) vor der thermischen Behandlung werden mehrere Verfahren angegeben. Der Hochtemperatursupraleiter (1) wird auf eine Supraleiter-Schichtdicke (dl) von < 500 µm eingestellt. Ein Verhältnis von einer Bypaß-Schichtdicke (d2) der Edelmetall-Bypaßschicht (2) zur Supraleiter-Schichtdicke (dl) wird auf < 1/5 eingestellt.

## Beschreibung

### TECHNISCHES GEBIET

Bei der Erfindung wird ausgegangen von einem Verfahren zum Legieren einer Edelmetall-Bypaßschicht eines Hochtemperatursupraleiters nach dem Oberbegriff des Patentanspruchs 1.

### STAND DER TECHNIK

Mit dem Oberbegriff des Patentanspruchs 1 nimmt die Erfindung auf einen Stand der Technik Bezug, wie er aus der US-A-5,079,223 bekannt ist. Dort ist ein Verfahren zur Herstellung eines Verbundes angegeben, bei dem ein Hochtemperatursupraleiter mittels Ionenstrahlverdampfung oder Aufstäuben mit einer 30 nm - 100 nm dicken Edelmetallschicht aus Silber oder Gold oder deren Legierungen versehen wird. Dieser Verbund wird mittels eines Bindemittels aus In, Ga, Sn, Bi, Zn, Cd, Pb, Tl oder deren Legierungen, welche mit dem Edelmetall intermediäre Phasen oder feste Lösungen bilden können, bei einer Temperatur von < 400 °C (unterhalb des Schmelzpunktes dieser Metalle) mit einem Metallsubstrat aus Kupfer oder Aluminium oder Blei oder Zink oder deren Legierungen durch Zusammenpressen verbunden. Über den spezifischen elektrischen Widerstand der so erhaltenen Bypaßschicht zum Hochtemperatursupraleiter sind diesem Patent keine Angaben zu entnehmen.

Aus der JP 06-309955 A (in Patent Abstracts of Japan) ist es bekannt, mit Silber beschichtete Hochtemperatursupraleiter mit einem Pb-Sn-Lot zu imprägnieren.

Aus der US-A4,914,081 ist es bekannt, auf einen Hochtemperatursupraleiter durch elektrolytische Abscheidung eine Metallschicht aus Silber oder Kupfer oder Zinn oder Blei oder Zink oder Kadmium oder Indium oder Nickel oder deren Legierungen aufzubringen.

Aus der EP 0592797 B1 ist ein Verfahren zur Herstellung eines rotationssymmetrischen Formteiles eines Hochtemperatursupraleiters bekannt, bei dem das in die Schmelzform eingesetzte Metall, vorzugsweise aus Silber oder Gold oder aus einer Legierung dieser Metalle, als gutleitender Bypaß wirkt, wenn der Hochtemperatursupraleiter für Abschirmzwecke eingesetzt werden soll. Über ein Verfahren zum Legieren z. B. einer Silber-Schmelzform finden sich dort keine Angaben.

Für einen Einsatz eines Hochtemperatursupraleiters als Strombegrenzer in Wechselstromleitungen, insbesondere für elektrische Leistungen von ≥ 1 MW, ist die Verwendung eines elektrischen Bypasses aus reinem Edelmetall ungeeignet, da dieser wegen seines geringen spezifischen elektrischen Widerstandes, z. B. von 0,35 µΩ · cm bei 77 K für Silber, für eine wirtschaftliche Strombegrenzung ungeeignet ist. Wünschenswert wäre ein elektrischer Bypaß, dessen elektrischer Widerstand kleiner ist als derjenige des Hochtemperatursupraleiters im nicht supraleitenden Zustand.

### DARSTELLUNG DER ERFINDUNG

Die Erfindung, wie sie im Patentanspruch 1 definiert ist, löst die Aufgabe, ein Verfahren zum Legieren einer Edelmetall-Bypaßschicht eines Hochtemperatursupraleiters der eingangs genannten Art anzugeben, mit dem der spezifische elektrische Widerstand einer vorher reinen Edelmetall-Bypaßschicht bei einer Temperatur von 77 K um mehr als das 10fache erhöht werden kann.

Vorteilhafte Ausgestaltungen der Erfindung sind in den abhängigen Patentansprüchen definiert.

Ein Vorteil der Erfindung besteht darin, daß ein derartiger Hochtemperatursupraleiter als Strombegrenzer in Wechselstromleitungen einsetzbar wird.

Gemäß einer vorteilhaften Ausgestaltung der Erfindung kann eine Erhöhung des spezifischen elektrischen Widerstandes einer vorher reinen Silber-Bypaßschicht um das 20fache erreicht werden.

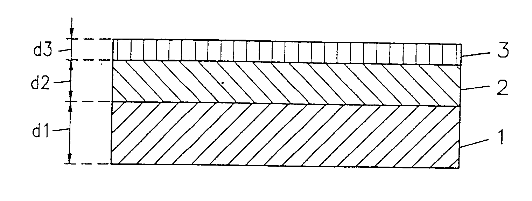

### KURZE BESCHREIBUNG DER ZEICHNUNG

Die Erfindung wird nachstehend anhand von Ausführungsbeispielen erläutert. Die einzige Figur zeigt eine Schichtenfolge von Hochtemperatursupraleiter, Edelmetall-Bypaßschicht und Legierungsmetallschicht vor dem Legieren.

### WEGE ZUR AUSFÜHRUNG DER ERFINDUNG

Gemäß der einzigen Figur steht eine Schicht aus einem keramischen Hochtemperatursupraleiter (1), der eine gleichmäßige Supraleiter-Schichtdicke (d1) aufweist, in gutem elektrischem und wärmeleitendem Kontakt mit einer Edelmetall-Bypaßschicht (2), welche eine gleichmäßige Bypaß-Schichtdicke (d2) aufweist. Auf diese Edelmetall-Bypaßschicht (2) ist eine Legierungsmetallschicht (3) mit einer gleichmäßigen Legierungsmetall-Schichtdicke (d3) aufgebracht.

Der Hochtemperatursupraleiter (1) ist vorzugsweise vom Typ: Bi₂₊ₓEA₃Cu₂O_{y} mit -0,15 < x < 0,4, 8 ≤ y ≤ 8,3, EA = ein Erdalkalimetall oder ein Gemisch aus Erdalkalimetallen, insbesondere ein Gemisch aus Sr und Ca im Verhältnis Sr : Ca = (2 + z) : (1 - z) mit 0 < z < 0,2.

Die zu legierende Edelmetall-Bypaßschicht (2) besteht vorzugsweise aus Silber (Ag). Die Legierungsmetallschicht (3) enthält Blei (Pb) und/oder Wismut (Bi) und/oder Zinn (Sn) und/oder Indium (In) und/oder Gallium (Ga) und/oder Aluminium (Al) und/oder Quecksilber (Hg), vorzugsweise Blei oder Wismut oder Gallium oder Aluminium.

Das Legieren der Edelmetall-Bypaßschicht (2) erfolgt vorzugsweise durch Diffundieren der Nichtedelmetalle der Legierungsmetallschicht (3) mittels einer thermischen Behandlung.

Wichtig ist, daß der Hochtemperatursupraleiter (1) auf eine Supraleiter-Schichtdicke (d1) von < 500 µm eingestellt wird. Ein Verhältnis von einer Bypaß-Schichtdicke (d2) der Edelmetall-Bypaßschicht (2) zur Supraleiter-Schichtdicke (d1) ist auf < 1/5 einzustellen.

Es versteht sich, daß die gewünschte Legierung auch durch Ionenimplantation hergestellt werden kann, was jedoch mit relativ hohen Kosten verbunden ist.

Auf eine Edelmetall-Bypaßschicht (2) aus einer Silberfolie mit einer Bypaß-Schichtdicke (d2) von 50 µm wird eine Wismutschicht mit einer Legierungsmetall-Schichtdicke (d3) von 0,5 µm aufgebracht:
a) durch direktes Löten auf der Oberfläche der Silberfolie (2) oder
b) durch Eintauchen der Silberfolie (2) allein oder der Schichtenfolge: Hochtemperatursupraleiter (1) und Edelmetall-Bypaßschicht (2) aus Silber in ein Bi oder Bi/Ag-Bad bei einer Temperatur von 400 °C oder
c) durch Zerstäuben von Bi unter Vakuum oder
d) durch elektrochemische Ablagerung aus einer handelsüblichen, Bi enthaltenden Lösung.

Anschließend wird dieser so entstandene Schichtenaufbau während einer Temperdauer von 1 h bei einer Tempertemperatur im Temperaturbereich von 200 °C - 400 °C, vorzugsweise bei 350 °C, in reiner Stickstoffatmosphäre getempert. Wichtig ist, daß während dieser Wärmebehandlung eine Oxydation des Bi verhindert wird.
Ausführungsbeispiel 1:
   Eine 40 µm dicke Silberfolie (2) und ein Hochtemperatursupraleiter (1) mit 20 µm Silber wurden in ein 400 °C heißes Wismutbad eingetaucht und danach 1 h lang bei 350 °C in Stickstoffatmosphäre angelassen. Anschließend wurde langsam abgekühlt auf Zimmertemperatur. Der spezifische elektrische Widerstand der entstandenen Legierung betrug 6,28 µΩ · cm bei 77 K.
Ausführungsbeispiel 2:
   Auf eine 2 cm breite und 50 µm dicke Silberfolie (2) wurde eine 1 cm breite und 20 µm dicke Aluminiumfolie gelegt. Danach folgte eine 1stündige Temperung in Stickstoffatmosphäre bei 650 °C. Der spezifische elektrische Widerstand der entstandenen Legierung betrug 8,8 µΩ · cm bei 77 K.
Ausführungsbeispiel 3:
   Silberfolien (2) mit Schichtdicken (d2) von 20 µm, 30 µm und 50 µm wurden mit flüssigem Gallium bestrichen, so daß diese danach mit einer Legierungsmetall-Schichtdicke (d3) von 10 µm bedeckt waren. Diese 3 Proben wurden 4 h bei 90 °C in Luft getempert und anschließend gekühlt. Der spezifische elektrische Widerstand der entstandenen Legierung betrug 8,4 µΩ · cm bzw. 5,0 µΩ · cm bzw. 2,6 µΩ · cm, jeweils bei 77 K; er erhöhte sich mit zunehmender Temperdauer und zunehmender Tempertemperatur. Wurden die 3 Proben 4 h lang bei 450 °C getempert, so war deren spezifischer elektrischer Widerstand > 10 µΩ · cm. Vorzugsweise wird das Legierungsmetall Gallium während einer Dauer im Bereich von 1 h - 5 h bei einer Temperatur im Bereich von 400 °C - 500 °C getempert.

### BEZEICHNUNGSLISTE

- 1: Hochtemperatursupraleiter
- 2: Edelmetall-Bypaßschicht, Silberschicht
- 3: Legierungsmetallschicht, Nichtedelmetallschicht
- d1: Supraleiter-Schichtdicke
- d2: Bypaß-Schichtdicke
- d3: Legierungsmetall-Schichtdicke8

## Patentansprüche

1. Verfahren zum Legieren einer Edelmetall-Bypaßschicht (2) eines keramischen Hochtemperatursupraleiters (1),
a) wobei auf die zu legierende Schicht (2) mindestens eine Legierungsmetallschicht (3) aufgebracht wird,
dadurch gekennzeichnet,
b) daß der Hochtemperatursupraleiter (1) auf eine Supraleiter-Schichtdicke (d1) von < 500 µm eingestellt wird,
c) daß ein Verhältnis von einer Edelmetallbypaß-Schichtdicke (d2) der Edelmetall-Bypaßschicht (2) zu einer Supraleiter-Schichtdicke (d1) auf < 1/5 eingestellt wird und
d) daß eine Dicke (d3) der Legierungsmetallschicht (3) so eingestellt wird, daß der spezifische elektrische Widerstand einer Gesamtbypaßschicht aus der Edelmetall-Bypaßschicht (2) und der Legierungsmetallschicht (3) zum Hochtemperatursupraleiter (1) gegenüber dem spezifischen elektrischen Widerstand einer vorher reinen, unlegierten Edelmetall-Bypaßschicht (2) bei einer Temperatur von 77 K um mehr als das 10fache erhöht ist.

2. Verfahren nach Anspruch 1, dadurch gekennzeichnet, daß das Aufbringen der Legierungsmetallschicht (3) auf die zu legierende Schicht (2, 1) durch direktes Löten mindestens eines Legierungsmetalls auf mindestens eine Oberfläche der zu legierenden Schicht (2) vorgenommen wird.

3. Verfahren nach Anspruch 1, dadurch gekennzeichnet, daß das Aufbringen der Legierungsmetallschicht (3) auf die zu legierende Schicht (2) durch Eintauchen der zu legierenden Schicht (2) allein oder der Schichtenfolge:
Hochtemperatursupraleiter (1) und Edelmetall-Bypaßschicht (2) in ein mindestens ein Legierungsmetall enthaltendes Bad vorgenommen wird.

4. Verfahren nach Anspruch 1, dadurch gekennzeichnet, daß das Aufbringen der Legierungsmetallschicht (3) auf die zu legierende Schicht (2) durch Zerstäuben mindestens eines Legierungsmetalls unter Vakuum vorgenommen wird.

5. Verfahren nach einem der vorhergehenden Ansprüche, dadurch gekennzeichnet,
a) daß die Edelmetall-Bypaßschicht (2) überwiegend Silber enthält und
b) daß als Legierungsmetall für die Legierungsmetallschicht (3) Aluminium eingesetzt wird.

6. Verfahren nach einem der vorhergehenden Ansprüche, dadurch gekennzeichnet, daß dieser Schichtenaufbau mindestens 50 min lang bei einer Tempertemperatur von mindestens 80 °C getempert wird.

7. Verfahren nach einem der Ansprüche 1 bis 5, dadurch gekennzeichnet,
a) daß die Edelmetall-Bypaßschicht (2) überwiegend Silber enthält,
b) mit Gallium legiert und
c) während einer Temperdauer im Bereich von 1 h - 5 h bei einer Tempertemperatur im Bereich von 400 °C - 500 °C getempert wird.
